# EUROPEAN PATENT APPLICATION

(11) **EP 0 844 651 A1**
(43) Date of publication of application: **27.05.1998**
(21) Application number: 97309242.2
(22) Date of filing: 18.11.1997
(51) Int. Cl.: H01L 21/316, H01L 21/18, H01L 33/00, H01S 3/19

(54) **Method of controlling oxidation in multilayer semiconductor structure comprising Group III elements**

(30) Priority: 26.11.1996 US 756663
(71) Applicant: XEROX CORPORATION, Rochester, New York 14644 (US)
(72) Inventor: Sun, Decai, Sunnyvale, California 94087 (US); Floyd, Philip D., Sunnyvale, California 94086 (US)
(74) Representative: Pike, Christopher Gerard

(57) **Abstract**

The present invention relates to a method of controlling oxidation in Group III-V semiconductor materials. Specifically, this technique includes a layer disordering step, which accurately defines the regions to be oxidized, prior to an oxidation step. It allows for local modification of the composition profile of a heterostructure after the epitaxial growth process. It also allows for accurate control of the regions of a semiconductor heterostructure within which oxidation can occur.

## Description

The present invention relates generally to techniques to oxidize semiconductor materials. More specifically, the invention relates to techniques which can selectively oxidize regions of a multilayer semiconductor structure.

The formation of high-quality native oxides is an important factor in the development of optical and electronic devices in III-V compound semiconductors. Such devices require the formation of dense, stable, and insulating native oxides on the semiconductor materials in order to achieve the necessary performance. Native oxides are generally more desirable than deposited oxides in that they are monolithic with the unoxidized regions of the crystal. This characteristic prevents problems of potential mismatching of dielectric characteristics and the problems associated with oxide-substrate interface bonding, which often creates lifting and cracking. Further, deposition processes are on the whole more complicated and more costly than methods of growing a native oxide, making the latter more attractive for commercial use. Thus, there is a continuing need for improved methods of growing high-quality native oxides in Group III-V semiconductor materials.

Unfortunately, success in forming high-quality native oxides on Ill-V semiconductor compounds has been limited. In general, native oxides of III-V compound semiconductors have poor electrical properties or mechanical properties or both. They are also porous, making them ineffective in masking impurity diffusion. This inability to form high-quality native oxides has impeded the development of electronic and optoelectronic integrated circuits in III-V compound semiconductors.

Currently, a common approach is to use an aluminum-containing compound semiconductor such as AlₓGa₁₋ₓAs with a relatively high aluminum content to form high-quality native Ill-V oxides. A key requirement appears to be the presence of aluminum in the semiconductor. These oxides are typically formed by reacting AlₓGa₁₋ₓAs with water vapor (H₂O) in a nitrogen environment at elevated temperatures, in excess of 400°C, which generally results in stable oxides of AIO(OH) and Al₂O₃ compounds. Such compounds can be used as a mask during device fabrication, a dielectric material for electrical isolation, a low-index material for optical confinement, as well as a cap for surface passivation. A description of the properties of native oxides of aluminum containing III-V compound semiconductors can be found in "Properties and Use of ln_{0.5}(AlₓGa₁₋ₓ)_{0.5}P and AlₓGa₁₋ₓAs Native Oxide in Heterostructure Lasers," J. Electronic Materials, vol. 21, No. 12, p.1133(1992), by Fletcher et al.

Specifically, the characteristics of such aluminum-containing native oxides appear to be adequate to mask zinc diffusion or to mask an impurity induced layer disordering ("IILD") process which either uses a vapor source or a solid source at 600°C to 800°C. They can also be used to reduce leakage current in electronic devices. Moreover, since AlGaAs native oxides exhibit a low refractive index (n) of around 1.6, they can be used for forming optical waveguides in index-guided lasers. Low-index oxides can be employed to form internal reflectors for Fabry-Perot cavities. A discussion of the use of oxides in forming internal reflectors may be found in "High reflectivity visible-wavelength semiconductor native oxide Bragg reflectors grown by metalorganic chemical vapor deposition" A. L. Holmes, et. al. Appl. Phys. Lett. Vol. 66, 2831-2833, 1995. In edge-emitting lasers, the native oxide of AlGaAs has been utilized to fabricate stripe-geometry and index-guided lasers. In vertical cavity surface emitting lasers, the native oxide of AlAs has been employed in forming distributed Bragg reflector ("DBR") structures.

Hence, aluminum-containing native oxides may provide a very useful fabrication technology for the realization of optoelectronic devices. An example which uses native oxides in forming lasers is described in "Lasing Characteristics of High-Performance Narrow-Stripe InGaAs-GaAs Quantum-Well Lasers Confined by AlAs Native Oxide," IEEE Photonics Technology Letters, vol. 8, No. 2, p. 176 (February 1996), by Cheng et al. However, in order to use native oxides for providing the necessary electrical and optical confinement in fabricating low-threshold, high-efficiency lasers, there is a need to control the oxidation of the semiconductor so that the oxidized regions are well-defined. One approach is a so-called "buried-layer" or buried-mesa" oxidation approach.

An example of the application of a "buried-layer" oxidation approach to forming a laser is described in "Lasing Characteristics of High-Performance Narrow Stripe InGaAs-GaAs Quantum-Well Lasers Confined by AlAs Native Oxide," IEEE Photonics Technology Letters, vol. 8, No. 2, p. 176 (February 1996) by Cheng et al. Under this approach, an AlGaAs layer with a higher aluminum content is placed above and below the active layer of a laser structure. Then, grooves are etched, forming a stripe mesa structure in between the grooves. As a result of the etching, the AlAs layers with a high aluminum content sandwiching the active layer are exposed at the edges of the mesa structure. To form the waveguides, these AlAs layers are oxidized laterally from the edges towards the center of the stripe mesa structure. Other layers in the structure remain essentially unoxidized since their aluminum content is lower. Consequently, their oxidation rates are also substantially lower. Therefore, the layers that are being oxidized are the ones made of AlAs. These oxidized AlAs layers reduce the effective refractive index of the regions both above and underneath them, providing lateral electrical and optical confinement to the sandwiched active region. Another approach in using the "buried-layer" technique is described in "High-Performance Planar Native-Oxide Buried-Mesa Index-Guided AlGaAs-GaAs Quantum Well Heterostructure Lasers," Appl. Phys. Lett. vol. 61 (3), p. 321 (July 1992) by Smith et al.

A key disadvantage of the "buried-layer" approach is the difficulty in controlling the amount of oxidation. Because the oxidation rate of AlGaAs depends strongly on aluminum composition, any composition non-uniformity will be reflected by changes in the oxidation rate, which in turn creates uncertainty in the amount of oxidation. The process is relatively temperature-sensitive. As the oxidation rate varies, it is difficult to ascertain the regions which will be oxidized, decreasing reproducibility in device performance. At times, if the oxidation rate is higher than expected, an entire AlAs layer may be oxidized so that an optical cavity can no longer be formed. Since the active region is defined by the oxidized layers, this process creates manufacturability and yield problems. Due to the difficulty in controlling oxidation rates, it is also difficult to form closely-spaced devices.

Another oxidation approach is commonly known as the "surface-oxidation" technique. Examples of such an approach are described in U.S. Patent No. 5,327,488 and U.S. Patent No. 5,262,360. Under the "surface-oxidation" approach, a cap GaAs layer is placed above a thick AlGaAs layer with a high aluminum content, which is formed above the active layer of a laser structure. Under this "surface-oxidation" approach, the sample is first masked with silicon nitride in certain areas, exposing parts of the GaAs cap layer. The exposed GaAs areas are then removed by chemical etching, exposing the underlying AlGaAs layer with a high aluminum content above the active region. The sample is then oxidized in water vapor where the oxidation in the AlGaAs layer proceeds downwards from the surface until it reaches the active region which has a lower aluminum content. Since the active region has a lower aluminum content, the oxidation process essentially stops when it reaches the active region.

Similar to the "buried-layer" oxidation technique, a disadvantage of the "surface-oxidation" technique is that it is sensitive to fluctuations in the fabrication process. For instance, the oxidation rate is dependent upon variations in the aluminum composition and the processing temperature. In addition, this technique is generally not applicable to a vertical cavity surface emitting laser ("VCSEL") structure which has alternate AlGaAs layers of high and low aluminum contents in an upper internal reflector. Accordingly, there exists a need to develop a technique which can produce well-defined and well-controlled oxidized regions.

According to one aspect of the present invention, there is provided a method of controlling oxidation in a multilayer semiconductor structure containing Group III elements, the method comprising the steps of: (a) forming a mask on said multilayer semiconductor structure to define a first region; (b) using a disordering agent to induce layer disordering within said first region of said multilayer semiconductor structure; (c) annealing said multilayer semiconductor structure to induce intermixing of said Group III elements within said first region; and (d) oxidizing a second region which is defined by said first region of said multilayer semiconductor structure.

The present invention provides a technique which can accurately define and control the regions of a semiconductor heterostructure which would be oxidized. This technique generally includes a layer disordering step, which defines the regions to be oxidized, prior to an oxidation step. Generally, a heterostructure is formed by at least a layer with a wide bandgap and a layer with a narrow bandgap. In the GaAs/AlGaAs material system, the bandgap of a material increases as the aluminum composition of the material increases. Hence, a heterostructure may be formed with a layer of AlGaAs with a high aluminum content and a layer of AlGaAs with a low aluminum content. Binary AlAs and GaAs may also be used.

Since higher aluminum composition in an AlGaAs layer leads to much faster oxidation rates, the boundaries of an AlAs layer to be oxidized can be defined by epitaxial growth. By sandwiching the AlAs layer with two AlGaAs layers with a lower aluminum content, the boundaries of oxidized regions which are parallel to the substrate are defined. In the present invention, layer disordering is used to gain an additional degree of control over the aluminum composition of a structure, thereby defining the regions within which oxidation can occur. Layer disordering is used in the present invention to locally alter the aluminum composition so that well-controlled selective oxidation of regions within a heterostructure can be achieved. It allows for the intermixing of some interfaces without intermixing others above or below them. Additionally, layer disordering permits selective intermixing of regions laterally adjacent to each other.

During the layer disordering process, the Group III elements of the layers in the heterostructure intermix, altering the aluminum composition of each layer. In general, the aluminum composition decreases in the layer which originally had a high aluminum content while the aluminum composition increases in the layer with a low aluminum content. The regions of the heterostructure which would be intermixed can be defined by the placement of a disordering agent in the structure which causes layer disordering. Buried finite impurity source may be used to accomplish highly localized intermixing. In other words, the present invention allows for the modification of doping and material profiles of a heterostructure even after the epitaxial growth process. For instance, typical sources which can cause layer disordering include p- or n-type impurities or Group III or V vacancies.

An advantage of this invention is that it allows for selective oxidation in the horizontal and vertical directions. The selectively oxidized regions can be defined by an embedded source or an external source. Typical embedded sources include dopants or impurity monolayers, and typical external sources include ion implantation or a surface layer which introduces impurities or vacancies.

Another advantage is that the present invention allows for the formation of an oxidized region of any arbitrary shape because the shape of the oxidized region is defined by layer disordering, which is defined by photolithography. In addition, crystal orientation no longer has a substantial impact on the shape of an oxidized region. The oxidized region typically has smooth and well-defined boundaries. This characteristic enables the formation of closely-packed and well-defined microstructures and devices.

Yet another advantage of this invention is that the resulting oxidized region can provide electrical or optical confinement or both in devices.

A further advantage of this invention is that it depends upon the difference in the aluminum mole fractions of two regions--the region in which oxidation is desired and the region in which oxidation is not desired. This invention does not depend upon the absolute aluminum mole fractions of the two regions. Since the oxidation rates in aluminum-containing semiconductors generally depends upon the aluminum mole fraction in an exponential manner, this process tends to be very reproducible. Consequently, the yield of the devices formed by the present invention would also be higher.

FIG. 1 illustrates the layers formed on a GaAs substrate for use in the fabrication of the preferred embodiment of the present invention.

FIG. 2 illustrates a heterostructure which has been selectively intermixed by layer disordering so that the regions of the AlAs layer which would be oxidized are clearly defined. The aluminum mole fraction of the intermixed region is probably less than 95%.

FIG. 3 illustrates the formation of oxidized regions defined by a region which has been intermixed by layer disordering.

FIG. 4 illustrates a diamond-shaped aperture formed by the oxidation of an AlAs buried layer defined by a circular mesa structure formed by etching.

FIG 5. illustrates a long and uneven aperture formed by oxidation of a region defined by an etched mesa structure.

FIG. 6 illustrates a smooth circular aperture that can be achieved by oxidizing a region of a circular etched mesa structure which has undergone a layer disordering process under the present invention.

FIG. 7 illustrates a long and narrow aperture that can be achieved by oxidizing a region of an etched mesa structure which has undergone a layer disordering process under the present invention.

FIG. 8 shows a graphical representation of the dependence of oxidation rates upon the aluminum mole fraction of a structure and the processing temperature.

FIG. 9 illustrates a semiconductor structure which can be used to implement an alternative embodiment of the present invention.

FIG. 10 illustrates a region which has been intermixed by layer disordering under a silicon dioxide cap structure, which acts as a sink for gallium atoms.

FIG. 11 illustrates the formation of native oxides on an AlAs layer, The oxidized regions are defined by the region which has been intermixed by layer disordering.

FIG. 12 illustrates another embodiment of the present invention which uses a surface impurity source such as silicon during the layer disordering process.

FIG. 13 illustrates the resulting structure of another embodiment of the present invention in which the surface impurity source is used to achieve layer disordering.

FIG. 14 illustrates the use of an ion implantation process to define a region of a heterostructure to be disordered by layer disordering.

FIG. 15 illustrates a region capped by silicon nitride which has been intermixed by layer disordering.

FIG. 16 illustrates the formation of native oxide in an AlAs layer. The oxidized regions are defined by an intermixed region formed by layer disordering.

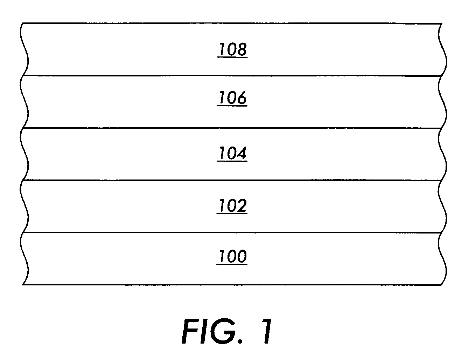

The preferred embodiment of the present invention uses a buried impurity source to intermix the layers which form a heterostructure. Generally, this buried impurity source can be the dopants embedded in one of the layers to be intermixed or a thin layer of impurities adjacent to or in proximity of one of the layers to be intermixed. FIG. 1 illustrates a semiconductor structure which is used to implement the preferred embodiment of the present invention. The semiconductor structure shown in FIG. 1 has a layer with a higher aluminum content 104 and a layer with a lower aluminum content 102 or 106. The dopants in the layer with a higher aluminum content act as the buried impurity source.

As shown in FIG. 1, an AlₓGa₁₋ₓAs layer 102 with a lower aluminum content is deposited on a GaAs substrate 100 using an epitaxial deposition process known as metal-organic chemical vapor deposition (MOCVD). Other deposition processes such as liquid phase epitaxy (LPE), molecular beam epitaxy (MBE), or other known crystal growth processes can also be used. A typical aluminum mole fraction of the AlGaAs layer 102 is approximately 40%. Nothing in this invention prevents the use of a GaAs layer or an AlGaAs layer with a higher or a lower aluminum mole fraction. As stated previously, the difference between the mole fractions of the region to be oxidized and the region not to be oxidized determines the controllability and reproducibility of the present invention. Under this embodiment, the AlGaAs layer 102 is typically doped with silicon at a level of 5 x 10¹⁷ cm⁻³. A different doping species or a different doping level may also be used depending upon the applications. For instance, beryllium, magnesium, or zinc may be used if a p-type dopant is desired.

After the AlGaAs layer 102 has been deposited, a layer with a high aluminum content such as an AlAs layer 104 is formed. This AlAs layer 104 typically has a higher silicon doping of 5 x 10¹⁸ cm⁻³ or higher, which provides a source of impurities for layer disordering. Although an AlAs layer 104 is used in the preferred embodiment, an AlGaAs layer which has a high aluminum content, when compared with that of its adjacent AlGaAs layers 102 or 106, may also be used. Generally, a mole fraction of approximately 90% or above is used for the layer with a high aluminum content. In this embodiment, above the AlAs layer 104 is another Al_{y}Ga_{1-y}As layer 106, on which a GaAs cap layer108 is formed. A typical aluminum mole fraction of the AlGaAs layer 106 is approximately 40%, and is doped by silicon at a level of approximately 5 x 10¹⁷ cm⁻³ or higher. Again, the aluminum content and the doping level may vary depending upon the applications. These two AlGaAs layers 102 and 106. which sandwich the AlAs layer 104 define the perimeters within which oxidation occurs if there is no layer disordering among the layers.

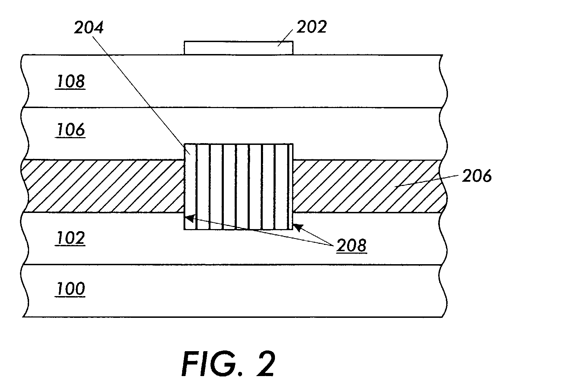

After all the semiconductor layers shown in FIG. 1 have been formed, a disordering-oxidation process is carried out. First, silicon nitride (SiNₓ) shown in FIG. 2 is deposited over the entire sample. Then, using a mask, the silicon nitride is removed from the areas under which oxide formation is desired. The sample, with a silicon nitride cap 202, undergoes an impurity induced layer disordering ("IILD") process of approximately 840°C for several hours. It is well-known that IILD can be used to intermix Group III atoms in a III-V semiconductor heterostructure as shown in U.S. Patent No. 5,386,428. It is also well-known that zinc or beryllium diffused under gallium-rich or arsenic-deficient conditions can be used to produce p-type disordering. A discussion of such a process can be found in U.S. Patent No. 5,376,583. Therefore, impurity-induced layer intermixing using a variety of impurity sources is well known.

In this embodiment, the buried impurity source is created by the dopants in the AlAs layer 104. During the IILD process, intermixing of the Group'III elements, gallium and aluminum, occurs under the silicon nitride cap 202. The intermixing is mostly limited to the region underneath the silicon nitride cap 202. This nitride cap 202 is believed to minimize the outdiffusion of arsenic and thus limit the scope of intermixing. The minimization of arsenic outdiffusion is believed to allow for the creation of Group III vacancies by silicon diffusion. These vacancies created by silicon diffusion then enable the intermixing of Group III elements among the two AlGaAs layers, 102 and 106, as well as the AlAs layer 104. However, in the event that p-type dopants are used to induce layer disordering, the silicon nitride cap 202 would instead cover the regions to be oxidized. With respect to the regions not covered by the silicon nitride cap 202, arsenic escapes from these regions, creating Group V vacancies or Group III interstitials or both. These Group V vacancies or Group III interstitials or both in turn induce the intermixing of Group III elements.

As shown in FIG. 2, the silicon nitride cap 202 defines the boundaries of the intermixed region 204 perpendicular to the substrate. The present invention is generally applicable to a heterostructure with layers of any thickness. However, the throughput of the process suffers in the event that thick layers are to be intermixed.

After the IILD process, the region of the AlAs layer 104 under the silicon nitride mask 202 has an aluminum content of less than 100% while at the same time, regions under the silicon nitride mask 202 in the AlGaAs layers 102 and 106 have a higher aluminum content. In other words, the intermixing introduces gallium into or removes aluminum from the AlAs layer 104, thus lowering the aluminum mole fraction of layer 104. Likewise, the intermixing introduces aluminum into or removes gallium from the AlGaAs layers 102 and 106, increasing their aluminum mole fractions. Minimal intermixing of Group III elements occurs under the areas not capped by silicon nitride 202 since inadequate Group III vacancies are generally generated in these areas. Generally, a relatively sharp interface 208 is created between the intermixed and the unintermixed region.

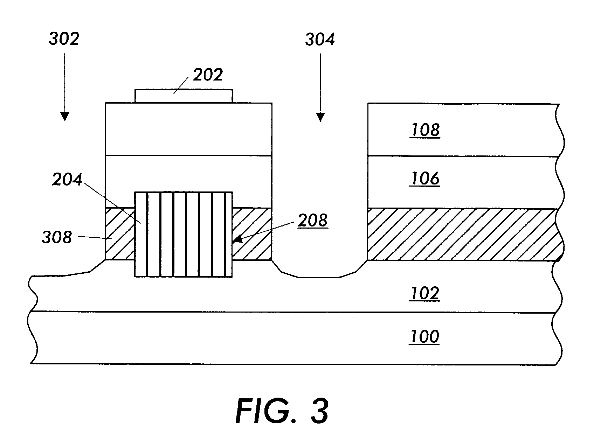

After the layer disordering process is completed, the semiconductor sample is then capped with silicon dioxide (SiO₂). Grooves 302 and 304 are etched as shown in FIG.3, forming a mesa structure and exposing the side-edges of the AlAs layer 104. The sample then undergoes an oxidation step in an environment with water vapor at a temperature of 400 to 450°C. At this point. as shown in FIG. 2, there exists a difference between the mole fraction of regions of the AlAs layer which has not been intermixed, 206, and the regions of the AlAs layer which has been intermixed, 204. The difference in aluminum mole fraction creates a disparity in oxidation rates since the oxidation rate of AlGaAs depends exponentially upon the aluminum mole fraction. For instance, the oxidation rate of AlAs is about 1.5 µm per minute at 450°C and is about 0.05 µm per minute for AlGaAs with about 80 percent aluminum. Due to this significant difference in the oxidation rates between the intermixed regions 204 and the unintermixed regions 206 of the AlAs layer 104, the oxidation process slows down substantially when it reaches the interface 208 between the intermixed and unintermixed regions. As shown in FIG. 3, this approach results in oxide formation only in the shaded regions 308, which can be controlled and defined in the horizontal and vertical directions. The boundaries of these oxidized regions are defined by the AlGaAs layers 102 and 106 in the vertical direction and by the silicon nitride cap 202 in the lateral direction as shown in FIG. 3. In addition, these boundaries are relatively smooth and sharp as they are defined by an epitaxial growth process or a photolithography process.

The present invention is equally applicable to a superlattice structure, which typically has alternate AlAs layer and AlGaAs or GaAs layer. A superlattice structure is often used in optoelectronic applications. The number of pairs of AlAs/AlGaAs required is often determined by the performance desired in a particular application. Typically, the thickness of each layer is about 3 nanometers, making the intermixing of Group III elements among the layers faster. When a superlattice is used, the throughput of the process may improve because the intermixing occurs in a shorter period of time as the layers become thinner.

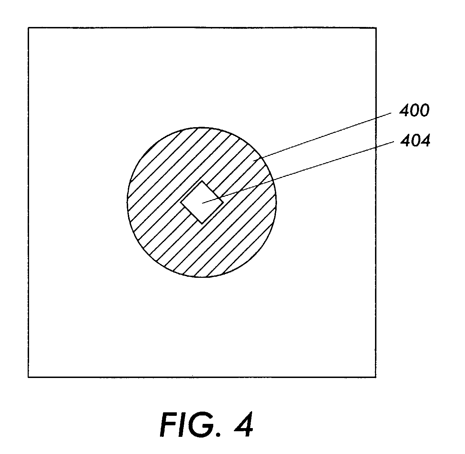

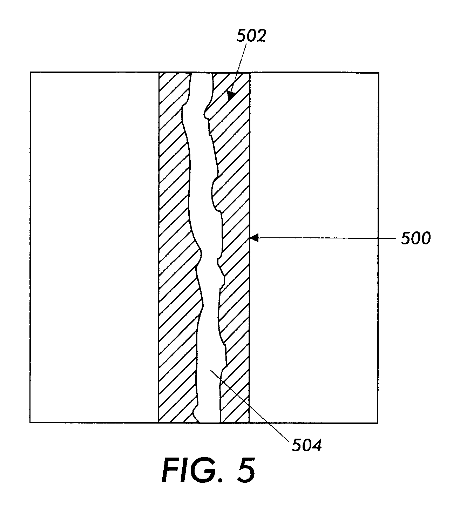

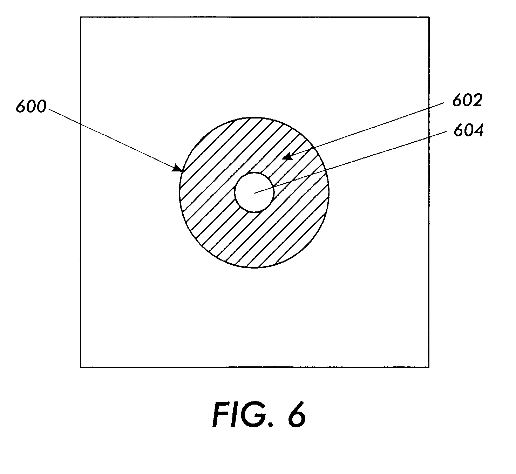

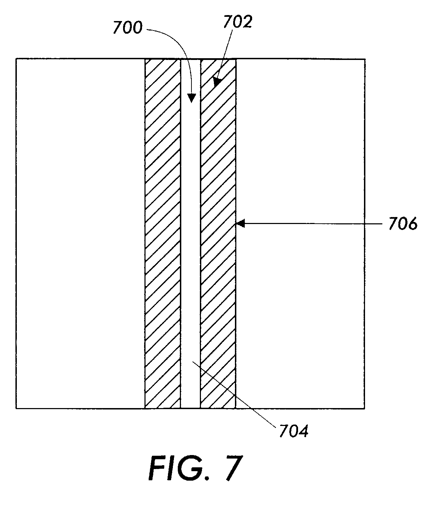

As stated previously, the boundaries of the oxidized regions under the present invention tend to be smooth. A typical oxidation process without a layer disordering step generally produces jagged and uneven boundaries because the oxidation rates of alloys depend upon their crystal orientation. For instance, as shown in FIG. 4, a donut-shaped mesa 400 formed by etching may be used to define a region of an AlAs layer to be oxidized. After the mesa has been etched, the sample is oxidized at a temperature of 400 to 500°C to define an unoxidized region capped by silicon nitride. This unoxidized region is commonly referred to as an "aperture" 404 of the mesa structure 400. As a result, during the oxidation step, only the shaded region of the mesa structure 400 is oxidized. The region capped by silicon nitride is not oxidized. However, the resulting non-oxidized region or aperture 404 is often not circular, but in a diamond shape as shown in FIG. 4. During the formation of the oxides, the oxidation rates are higher along certain crystal orientations, producing the diamond-shaped aperture 404. Likewise, as shown in FIG. 5, a mesa structure 500 is used to form a long and narrow unoxidized region 504. This unoxidized region, which is capped by silicon nitride during oxidation, is often referred to as an "aperture." Oxides are first formed in the shaded region 502 of the mesa structure. However due to uneven etching and defects in the structure, the resulting unoxidized region or aperture 504 defined by the shaded oxidized region 502 is jagged and uneven as shown in FIG. 5. In contrast, the present technique can produce a smooth circular unoxidized region or aperture 604 defined by layer disordering. The aperture 604 is formed by oxidizing a donut-shaped region 600 surrounding the aperture 604 as illustrated in FIG. 6. Under this approach, the region not to be oxidized is first intermixed by layer disordering before oxidation, thereby substantially reducing the oxidation rates in that area. Likewise, a long and narrow aperture 704 as shown in FIG. 7 can be achieved by first intermixing the Group III elements in the region 700 where the aperture will be formed. Then, a mesa structure 706 is formed to allow lateral oxidation. As shown in FIG. 7, the native oxide 702 surrounding the aperture 704 has smooth and sharp boundaries.

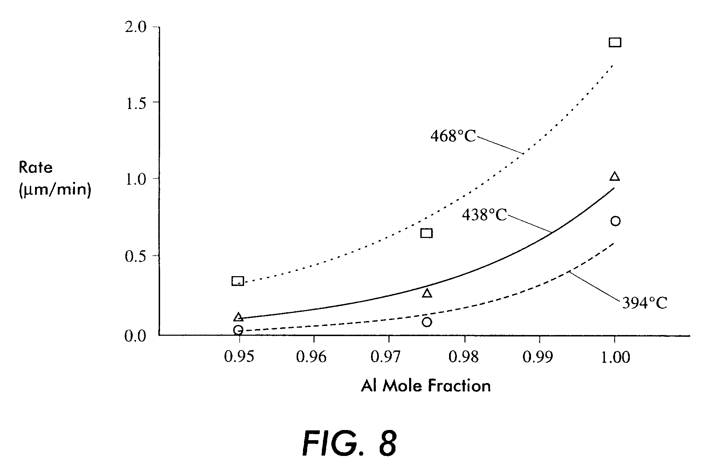

FIG. 8 illustrates the dependence of the oxidation rates of AlGaAs upon the aluminum mole fraction of the samples as well as the processing temperature. Data points represented by squares in FIG. 8 show the oxidation rates of samples with various aluminum mole fractions at 468°C. Oxidation rates of samples with various aluminum mole fractions at 438°C are represented by triangles. Data points represented by circles show the oxidation rates of samples with various aluminum mole fractions at 394°C. The aluminum mole fraction of the AlGaAs material ranges from 0.95 to 1. The oxidation rate increases with the aluminum content almost exponentially at a constant oxidation temperature. As the oxidation temperature increases from 394 °C to 468 °C, the AlGaAs alloy also has a higher oxidation rate.

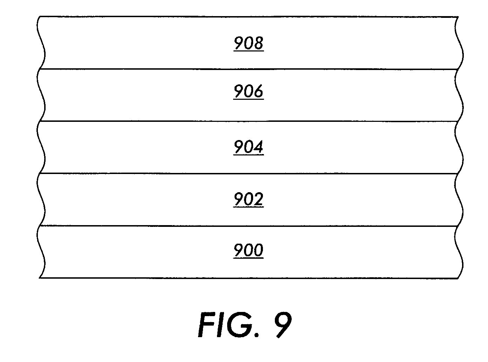

FIG. 9 illustrates a semiconductor structure which can be used to implement another embodiment of the present invention. This embodiment uses a vacancy-enhanced layer disordering process to intermix the Group III elements among layers of a heterostructure. Similar to FIG. 1, FIG. 9 is a multilayer structure on a GaAs substrate 900. Above the GaAs substrate 900 is an AlGaAs layer 902 which is grown by MOCVD. The AlGaAs layer 902 has a lower aluminum mole fraction than the layer above it, which is typically an AlAs layer 904. The mole fraction of the AlGaAs layer 902 is 40%. Rather than using an AlAs layer 904, an AlGaAs layer which has a higher aluminum mole fraction may also be used. The next layer deposited is another AlGaAs layer 906 with a relatively low aluminum content such as 40%. The two AlGaAs layers with lower aluminum content define the boundaries of the oxidized regions in the direction parallel to the substrate. Then, a GaAs cap layer 908 is deposited epitaxially.

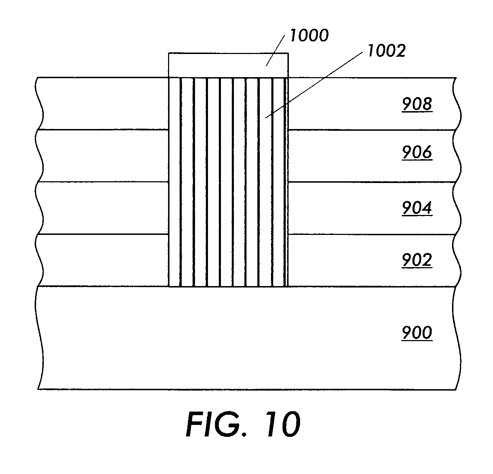

After the multilayer structure has been formed, a vacancy-enhanced layer disordering process is used to control the oxidation process and define the oxidized regions. First, a silicon dioxide layer is deposited on the structure. The silicon dioxide layer is then masked and etched. The areas where layer disordering is not desired are not masked by the silicon dioxide cap 1000 as shown in FIG 10. This silicon dioxide cap 1000, defines the boundaries within which intermixing occurs in the direction perpendicular to the substrate. Underneath the silicon dioxide cap 1000, there is probably less arsenic outdiffusion. In addition, the silicon dioxide cap 1000 also acts as a sink for gallium. As gallium atoms move towards the silicon dioxide cap 1000, Group III vacancies are created allowing for an intermixing of gallium and aluminum atoms in the region 1002 underneath the cap 1000. After the layer disordering process, the intermixed region 1002 typically has an aluminum mole fraction which ranges from 40% to 95%.

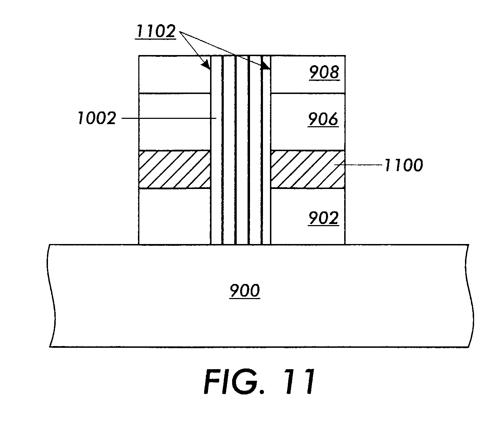

Grooves are then etched in the heterostructure, forming a mesa structure and exposing the side edges of the AlAs layer 904 shown in FIG. 10. The heterostructure is then placed in an environment with water vapor for oxidation. The water vapor oxidizes the AlAs layer 904 shown in FIG. 10 from the edges towards the center of the mesa structure until it reaches the interface 1102 between the intermixed and unintermixed regions. In other words, the oxidation process converts the portions of the AlAs layer 904 which have not been intermixed into native oxides 1100 as shown in FIG. 11.

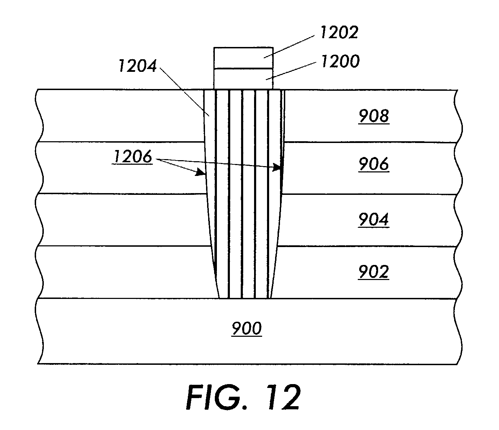

The structure shown in FIG. 9 may also be used to implement a third embodiment of the present invention. Under this alternative embodiment, a surface impurity source is used to disorder the multilayer structure shown in FIG. 12. A typical impurity source is a surface layer of silicon 1200 as shown in FIG. 12. Other dopants such as selenium, zinc, germanium, beryllium, or magnesium may also be used. Above the silicon layer 1200, a silicon nitride layer 1202 is deposited. Then, using a mask, the silicon nitride and the silicon layer are removed from the areas under which oxide formation is desired. The sample undergoes an IILD process of approximately 840°C for several hours. The silicon atoms diffuse into the region 1204, intermixing gallium and aluminum atoms. Under this approach, the extent to which disordering occurs underneath the silicon 1200 is essentially determined by a thermal diffusion process. Therefore, the interface 1206 of the intermixed region 1204 and the unintermixed region is generally not as sharp, tapering as the region goes further away from the impurity source. Longer time or higher temperature may produce a even more tapered intermixed region.

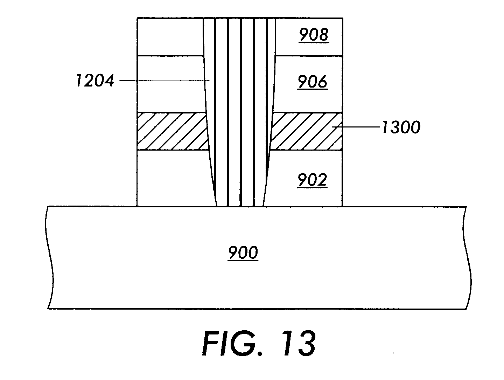

After the intermixing has occurred, the entire heterostructure is then capped with silicon dioxide. Grooves are etched, exposing the side-edges of the AlAs layer 904. The sample is then oxidized in water vapor at 400 to 450°C. The AlAs layer 904 is oxidized from the edges of the edged grooves towards the center of the mesa. Again, due to the significant difference in oxidation rate between the intermixed AlGaAs layer and the unintermixed AlAs layer, the oxidation slows down dramatically when it reaches the interface 1206 between the AlAs region 904 and the intermixed region 1204. The oxidation process converts the portions of the AlAs layer 904 which have not been intermixed into native oxides 1300 as shown in FIG. 13.

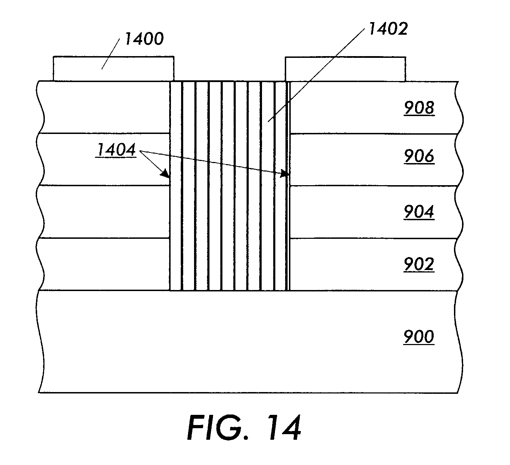

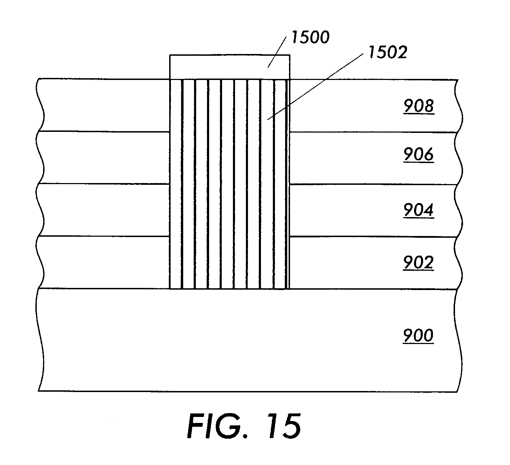

The structure shown in FIG. 9 may also be used to implement a fourth embodiment of the present invention. Under this embodiment, an ion implantation process is used to disorder the multilayer structure shown in FIG. 14. First, the structure is masked by photoresist 1400. The photoresist remains in areas under which oxide formation is desired. Silicon is then implanted. Other elements such as selenium or proton may also be used. In the case of proton implantation, intermixing is achieved by the generation of lattice damage or defects. The implanted region 1402 is shown in FIG. 14. Since ion implantation generally produces a sharp doping profile, the interface 1404 between the intermixed and unintermixed region is relatively sharp. After the ion implantation, the sample is capped with silicon nitride 1500 as shown in FIG. 15 in areas where oxidation is not desired. Then, the heterostructure undergoes an IILD disordering process of approximately 840°C for several hours, intermixing the gallium and aluminum atoms among the layers in the region 1502 underneath the cap 1500. The silicon nitride cap 1500 is believed to prevent outdiffusion of arsenic and thus allow for the creation Group III vacancies by the silicon atoms. The Group III vacancies in turn cause the intermixing of gallium and aluminum atoms underneath the cap 1500.

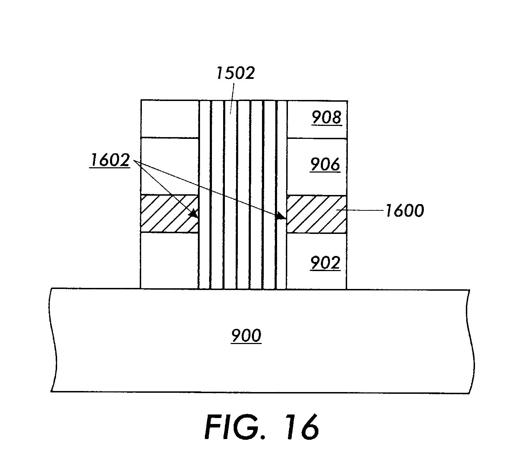

After the intermixing has occurred, the heterostructure is capped with a silicon dioxide layer. Grooves are again etched, exposing the side-edges of the AlAs layer 904. The structure is then oxidized in water vapor at a temperature of 400°C to 500°C. Again, due to the significant difference between the oxidation rate of the intermixed region 1502 and the unintermixed region, the oxidation essentially stops when it reaches the interface 1602 between the unintermixed region and the intermixed region. The oxidation process converts portions of the AlAs layer which has not been intermixed into native oxides 1600, which are indicated by the shaded regions in FIG. 16.

Other layers in addition to the ones shown in the figures may also be included. Variations in experimental conditions such as intermixing temperature, time, and oxidation temperature are also permitted. Instead of GaAs and GaAlAs, other semiconductor materials such as GaAISb, InAIGaP, or other III-V alloys may also be used.

## Claims

1. A method of controlling oxidation in a multilayer semiconductor structure containing Group III elements, the method comprising the steps of:
(a) forming a mask (202) on said multilayer semiconductor structure to define a first region (204);
(b) using a disordering agent to induce layer disordering within said first region (204) of said multilayer semiconductor structure;
(c) annealing said multilayer semiconductor structure to induce intermixing of said Group III elements within said first region (204); and
(d) oxidizing a second region (308) which is defined by said first region (204) of said multilayer semiconductor structure.

2. The method of Claim 1 wherein said disordering agent is said mask (202).

3. The method of either of Claims 1 or 2 wherein said mask (202) is for gettering of Group III elements.

4. The method of any of Claims 1 to 3 wherein said mask (202) is silicon dioxide.

5. The method of any of Claims 1 to 4 wherein said disordering agent is introduced into said multilayer semiconductor structure by ion implantation.

6. The method of any of Claims 1 to 5 wherein said disordering agent is a p-type impurity, preferably zinc.

7. The method of Claim 6 wherein said mask exposes the surface of said first region.

8. The method of any of Claims 1 to 5 wherein said disordering agent is an n-type impurity, preferably silicon.

9. The method of Claim 8 wherein said mask covers the surface of said first region.

10. An oxidized region (308) in a multilayer semiconductor structure obtainable by the method of any of Claims 1 to 9.
